# EUROPEAN PATENT SPECIFICATION

(11) **EP 1 135 978 B1**
(45) Date of publication and mention of the grant of the patent: **22.12.2004**
(21) Application number: 99954464.6
(22) Date of filing: 03.11.1999
(51) Int. Cl.: H05K 7/20

(54) **HEATSINK FOR ELECTRONIC COMPONENT, AND APPARATUS AND METHOD FOR MANUFACTURING THE SAME**
KÜHLKÖRPER FÜR EIN ELEKTRONISCHES BAUELEMENT,VORRICHTUNG UND VERFAHREN ZU DESSEN HERSTELLUNG
DISSIPATEUR POUR COMPOSANT ELECTRONIQUE ET DISPOSITIF ET PROCEDE PERMETTANT DE FABRIQUER CE DISSIPATEUR

(30) Priority: 04.11.1998 KR 9847121; 02.11.1999 KR 9948238
(43) Date of publication of application: 26.09.2001
(73) Proprietor: Zalman Tech Co., Ltd., Ansan-city, Kyungki-do (KR)
(72) Inventor: LEE, Sang, Cheol, Kunpo-city, Kyungki-do 435-040 (KR)
(74) Representative: Lorenz, Werner, Dr.-Ing.
(86) International application number: PCT/KR1999/000660
(87) International publication number: WO 2000/027177

(56) References cited:
- US-A- 5 794 685
- DATABASE WPI Week 199820, Derwent Publications Ltd., London, GB; AN 1998-223080/20, XP002947813 & JP 10 065 076 A (MATSUSHITA DENKI SANGYO) 06 March 1998 & PATENT ABSTRACTS OF JAPAN & JP 10 065 076 A 06 March 1998

## Description

### Technical Field

The present invention relates to a heatsink for dissipating heat from electronic components, such as components of a computer system, and an apparatus and method for manufacturing the heatsink.

### Background Art

Central processing units (CPUs), thermoelectric modules, power transistors, video graphics array (VGA) chips, radio frequency chips and the like are examples of electronic components. Since such electronic components produce a large amount of heat during operation, effective cooling thereof is an important concern. If an electronic component is heated over a predetermined temperature, an error may occur in the electronic component, or the electronic component may become damaged. For this reason, heatsinks are installed on such electronic components, which dissipate heat generated therefrom into air, thus lowering the temperature of the electronic component.

The ideal heatsink capable of effectively dissipating heat from an electronic component into air is made of a material having a high thermal conductivity, has a short thermally conductive pathway, a large heat conducting area and a large heat-dissipating area, and allows a smooth air flow near the heat dissipating area. In order to satisfy the requirements, a conventional heatsink is made by extruding an aluminum (Al) alloy and cross-cutting the extrusion, or by die casting Al.

However, these two methods cannot be applied to a material having a high thermal conductivity, for example, to copper (Cu) whose thermal conductivity is higher than that of Al alloy. Also, the conventional methods does not provide the heatsink with a sufficient large heat dissipating area and heat conducting area, and has a short thermally conductive pathway.

For example, U.S. Patent No. 5,419,780 discloses a heatsink manufactured through extrusion and cross-cutting. Thus, a highly thermal conductive material
cannot be used to manufacture the heatsink, and the heat conducting area and heat dissipating area of the heatsink are not large enough for effective heat transfer. Also, the thermally conductive pathway is long.

As another example, U.S. Patent No. 5,509,465 discloses a heatsink in which a plurality of fins having a flange spacing between each fin are overlapped. Although the heatsink has a large heat dissipating area, the heat conducting efficiency is low due to the long thermally conductive pathway, a small heat conducting area and the presence of a heat transfer boundary.

Such conventional heatsinks have high heat resistance and air must be forcibly circulated with the assistance of a fan for a more effective heat transfer from the electronic component to the air. For example, in order to appropriately maintain the temperature of a CPU which produces heat at a rate of 15W or more, a fan must be installed near the heatsink mounted on the CPU to lower the heat resistance.

As set forth above, the conventional heatsink requires a fan for appropriate heat dissipation, which has the inherent problems of high power consumption, noise and scattering and sticking of dust. In particular, noise must be eliminated so that the user can work in a quiet environment. Also, with increases in the speed of the CPU, heat generation from the CPU increases. However, the heat generated from the CPU hinders speed increases of the CPU. Thus, the problem associated with the generation of heat in the CPU must be avoided for a high-speed CPU.

### Disclosure of the Invention

To solve the above problems, an object of the present invention is to provide a heatsink for cooling a heat-generating electronic component, which has a low heat resistance and does not require a fan, so that cooling of the electronic component is possible without power consumption and without generating noise, and an apparatus and method for effectively manufacturing the heatsink for an electronic component.

The heatsink for an electronic part according to the present invention includes a combination of a plurality of heatsink plates. Each heatsink plate has a binding portion, where the plurality of heatsink plates are bound together and the bottom surface of the binding portion collectively forms a heat-absorbing portion for contacting a heat-dissipating surface of the electronic component, and a large-surface area portion which is spaced apart from corresponding parts of other heatsink plates, forming a heat-dissipating portion. There may be a plurality of spacers interleaved between and corresponding to the shape of the binding portions of neighboring heatsink plates to provide separation between heatsink plates at the heat-dissipating portion. However, the spacing at the heat-dissipating portion may be provided by spreading apart the heatsink plates away from each other above the binding portions at predetermined angles. There may be several bends to provide better airflow between surfaces and to provide a preferred overall shape. Preferably, a large surface area is provided at the heat-dissipating portion by being formed of a plurality of fins spaced apart from each other. The heatsink plates are bound at the binding portion by any one of many binding means including, but not limited to, a rivet, a nut and bolt combination, press bonding, a heat-conducting bond and lead solder. Preferably the binding means is a rivet. The plurality of binding portions and the plurality of spacers bound together are stacked so that the edges of the binding portions of the heatsink plates form a heat-absorbing surface for contacting a surface of a heat-generating source.

To enhance the heat-dissipating effect, and to more effectively cool electronic devices that produce a large amount of heat, a fan may be installed at the heatsink according to the present invention to blow air over the heatsink or a fan may be fitted to a separate bracket and installed to the heatsink.

To manufacture the heatsink according to the present invention, an apparatus is provided which includes a first jig having at least one hole, equal to the number of binding holes in each heatsink plate; at least one pin hammer, equal to the number of binding holes in each heatsink plate, to be inserted into the hole(s) of the first jig; a second jig having at least one groove, corresponding to the at least one hole of the first jig, where the head of a rivet is inserted; and a hammer for pushing the pin hammer against a rivet passed through the binding holes of the individual heatsink plates to deform the end of the rivet such that another head is formed on the rivet, wherein the individual heatsink plates are compressed between the first and second jigs at the binding portion of the individual heatsink plates as the apparatus binds the individual heatsink plates together by riveting a rivet through the binding holes at the binding portion of the individual heatsink plates. The inner sides of the first and second jigs, contacting the binding portions of the heatsink plates may have raised or depressed characters such that the characters can be carved into or molded at the outermost binding portion of the heatsink.

The method of manufacturing the heatsink according to the present invention includes (a) forming a binding hole in each heatsink plate, the binding hole being used to bind the plurality of heatsink plates together; (b) combining the plurality of heatsink plates; (c) fixing the combined heatsink plates by a fixing means; and (d) leveling the bottom surface of a binding portion of the heatsink plates, which allows the bottom surface to contact a surface of a heat-generating source. The method may also include the steps of forming at least one pair of a protrusion and an indentation in the binding portions of the heatsink plates, together with the binding hole, in the formation of the individual heatsink plates; and pressing the binding portions of the heatsink plates together such that the protrusion of a heatsink plate insert into the indentation of the adjacent heatsink plate, thereby binding the individual heatsink plates at the binding portion thereof. The method may also include the steps of forming at least one pair of a protrusions and an indentation at a portion of the heatsink plates other than the binding portions, together with the binding hole in the formation of the heatsink plates; and pressing the binding portion of the heatsink plates together, while an assembly rod is inserted into the binding hole such that the individual heatsink plates bend outward at predetermined angles at portions other than the binding portion. The step (b) of the method comprises: inserting a rivet into the binding hole; pressing the binding portion of the individual heatsink plate against the head of the rivet, wherein the end of the rivet passed through the binding hole, which is the opposite side to the head of the rivet, is not compressed; and compressing the end of the rivet passed through the binding hole to form another head of the rivet at the opposite side of the head of the rivet.

### Brief Description of the Drawings

FIG. 1 is a perspective view of a heatsink for an electronic component according to a preferred embodiment of the present invention;
FIG. 2 is a perspective view showing a state in which a fan is installed at the side of a heatsink according to another embodiment of the present invention;
FIG. 3 is a perspective view showing a state in which the heat-dissipating portion of individual heatsink plates of a heatsink according to the present invention are spread outwards;
FIG. 4 is a perspective view showing a state in which a fan is fixed to the top of a heatsink according to the present invention;
FIG. 5 is a perspective view showing a case in which spacers of a heatsink according to the present invention have side extensions;
FIG. 6 is a perspective view showing the case where spacers of a heatsink according to the present invention have extensions pointing downward;
FIG. 7 is a perspective view showing a heatsink having no fins in individual heatsink plate according to the present invention, and a fan fitted to a fan bracket;
FIG. 8 is a perspective view showing a heatsink plate of a heatsink according to the present invention having fins extending in a radial direction;
FIG. 9 is a perspective view of a complete heatsink in which the individual heatsink plates shown in FIG. 8 are combined;
FIG. 10 is a perspective view of a heatsink for an electronic component according to the present invention, having a reduced height;
FIG. 11 is a perspective view of a heatsink for an electronic component according to the present invention, having a reduced height and width;
FIG. 12 is a perspective view illustrating the installation of a clip that is used to fix a heatsink according to the present invention to an electronic component;
FIG. 13 is a perspective view illustrating the installation of a clip when an auxiliary heat-dissipating plate is interposed between an electronic component to be cooled and a heatsink according to the present invention;
FIG. 14 is a perspective view illustrating a state in which a heatsink for an electronic component according to the present invention is fixed to the electronic component that needs to be shielded from electromagnetic waves;
FIG. 15 is an exploded perspective view of a riveting device that is used to combine the binding portion of individual heatsink plates for an electronic component according to the present invention using rivets; and
FIGS. 16 and 17 are diagrams illustrating a method of manufacturing a heatsink for an electronic component according to the present invention.

### Best mode for carrying out the Invention

A good heatsink should effectively absorb the heat generated by heat-generating parts without power consumption and without generating noise and vibrations, and transfer the absorbed heat into the surrounding air. Also, the manufacture thereof should be easy. That is, a good heatsink is a heatsink capable of keeping the temperature of the heat-generating parts at the lowest level without using a cooling fan, and can be made easily. In addition, by installing a fan capable of forcibly blowing air over and around the heatsink, the heat dissipating efficiency should be further increased.

The technical idea of a heatsink according to the present invention, for satisfying the above conditions, is to manufacture a heatsink through a press process, which allows a plurality of heatsink units to be stacked on one another, using aluminum (Al) or copper (Cu) having a high thermal conductivity as the material, such that the thermally conductive pathway can be as short as possible. Also, the technical idea of the heatsink according to the present invention is to maximize the heat conducting area and heat dissipating area, and to allow smooth air flow near the heat dissipating area. Also, the technical idea of the present invention is to provide an easy method of manufacturing such a good heatsink. Throughout the description below, like reference numerals are used to refer to like elements.

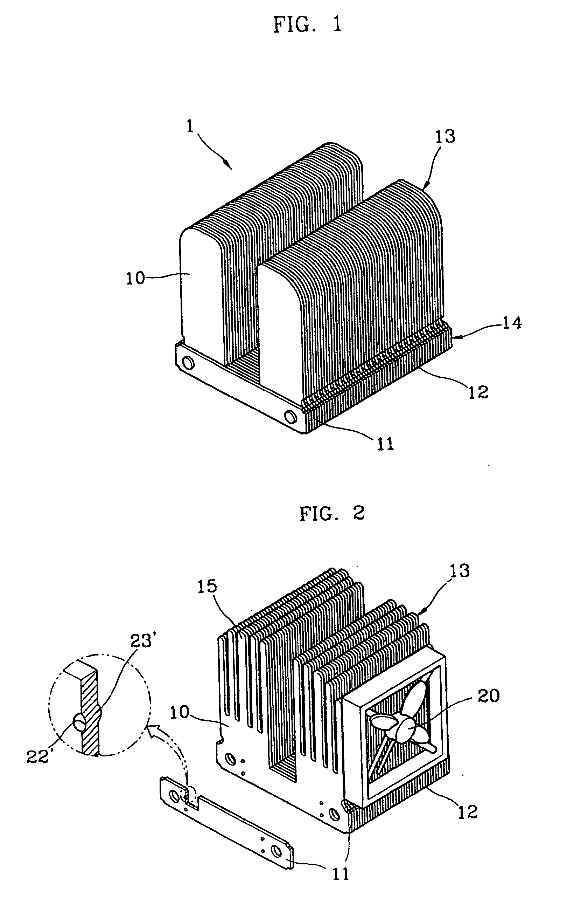

Referring to FIG. 1, a heatsink 1 according to the present invention includes a plurality of heatsink plates 10, which are stacked to one another, and spacers 11 interleaved between the heatsink plates 10. The individual heatsink plates 10 between which the spacers 11 have been interleaved are bound together at a binding portion. The binding portion absorbs heat from the electronic component in contact with a heat-dissipating surface of the electronic component. The bottom surface of the binding portion forms a heat-absorbing portion 12, and the opposite side of the heat-absorbing surface 12, the heatsink plates 10 spaced by the spacers 11, forms a heat-dissipating portion 13. The heat-absorbing surface 12 is attached to a flat surface of an electronic component (not shown) using a thermal conductive silicon grease (not shown) or an adhesive tape (not shown), to absorb the heat generated by the electronic component, and the heat-dissipating portion 12 dispatches the heat absorbed through the heat-absorbing surface 12 into air. The air flow becomes better as the thickness of each heatsink plate 10 becomes smaller than that of each spacer 11. Preferably, the heatsink plates 10 are formed of a material having a higher thermal conductivity than that used for the spacers 11. For example, the spacers 11 may be formed of Al, and the individual heatsink plates 10 are formed of Cu to a thickness that is half the thickness of each spacer 11. In the case where both the heatsink plates 10 and the spacers 11 are formed of Cu, the heat conducting efficiency increases. However, forming the heatsink plates 10 and the spacers 11 with Cu increases the weight of the heatsink 1, which is not desirable.

Referring to FIG. 2, the heat dissipating efficiency can be further increased by installing a fan 20 at the side of the heat-dissipating portion 13. Also, a plurality of fins 15 can be formed at the heat-dissipating portion 13 of the individual heatsink plates 10, which contributes to the smooth flow of air, thus increasing the heat-dissipating efficiency. When the fan 20 is installed at a side of the heat-dissipating portion 13, as shown in FIG. 2, the flow of air through the space between the heatsink plates 10 is facilitated, so that the heat-dissipating efficiency increases.

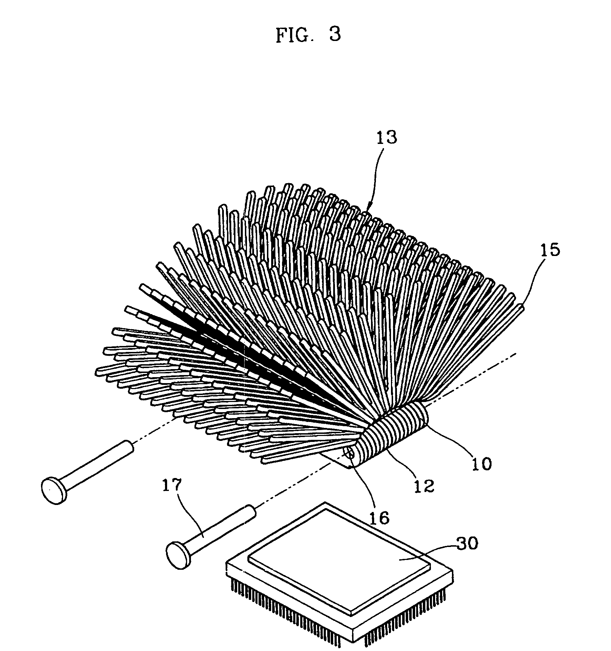

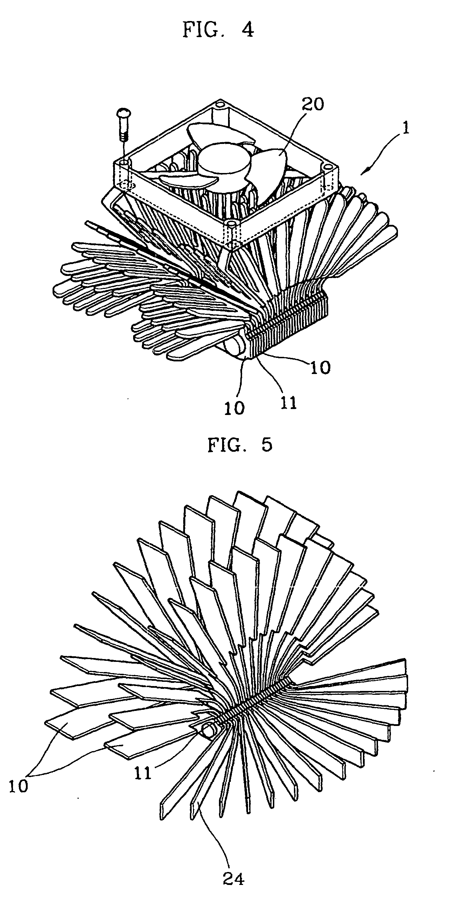

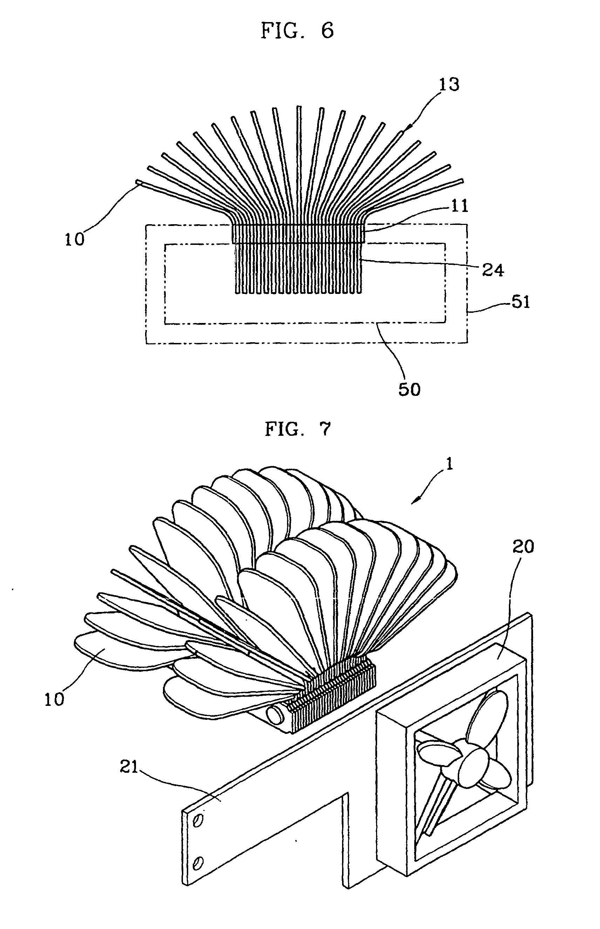

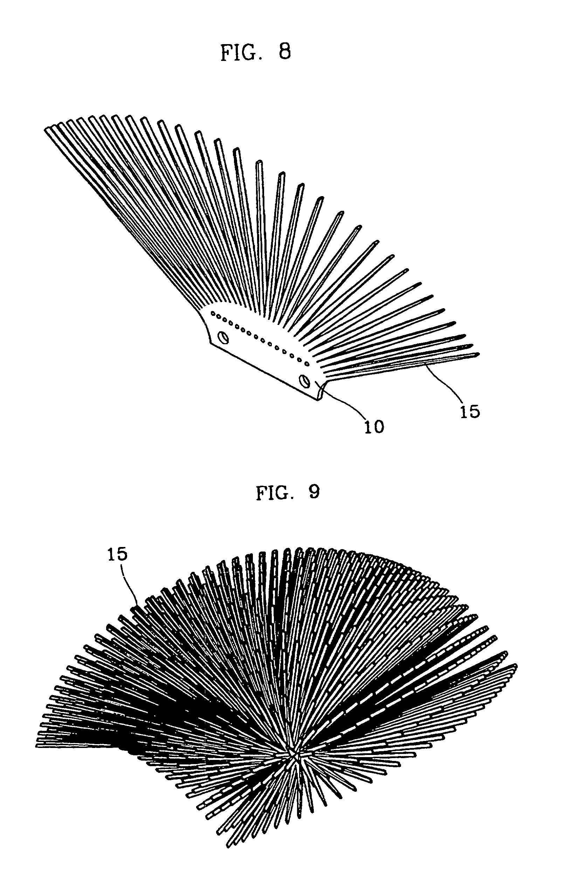

Referring to FIG. 3, the bottom surfaces of the individual heatsink plates 10 form the heat-absorbing surface 12 which absorbs heat from an electronic component 30, in contact with a heat-dissipating surface of the electronic component 30. Also, the individual heatsink plates 10 have a plurality of fins 15. However, unlike the heatsink shown in FIG. 2, each heatsink plate 10 is bent a predetermined angle. The individual heatsink plates 10 are joined to one another, near the heat-absorbing surface 12, by a rivet 17 as the binding means. In order to reduce the manufacturing cost or to increase the heat-dissipating efficiency, spacers 11 can be inserted between the individual heatsink plates 10 as shown in FIG. 4. In addition, the spacers 11 may have extensions 24 as shown in FIG. 5. As shown in FIG. 8, the heatsink plate 10 may be a sector shaped, having fins 15 extending in a radial direction, which allows a maximum heat-dissipating efficiency. The assembly of the heatsink plates 10 of FIG. 8 is shown in FIG. 9.

Alternatively, as shown in FIG. 6, extensions of the spacers 11 may be formed in a downward direction of the heatsink plates 10, that is, in the opposite direction to the heat-dissipating portion 13 of the heatsink plates 10. Thus, the heat generated from the heat-generating source is transferred to the extensions 24 of the spacers 11 and then dissipated through the heat-dissipating portion 13 of the heatsink plates 10. For example, as shown in FIG. 6, in the case where a hard disk drive 50 is surrounded by a sound insulating member 51 and the extensions 24 of the spacers 11 are located in the space formed by the sound insulating member 51, the heat from the hard disk drive 50 is transferred to the extensions 24 of the spacers 11. Then, the heat transferred to the extensions 24 of the spacers 11 is conducted to the heatsink plates 10 and then dissipated through the heat-dissipating portion 13 of the heatsink plate 10.

The fan 20, which facilitates the flow of air, may be attached atop the heatsink 1, as shown in FIG. 4. Alternatively, as shown in FIG. 7, the fan 20 may be installed at a separate fan bracket 21. In the case where such a fan bracket is adopted, the size of the fan 20 can be increased, so that the heat resistance of the heatsink 1 sharply decreases, in addition to lowering the noise generated by the fan 20. In the case where the fan 20 is installed at a side of the heatsink 1, as shown in FIG. 7, it is preferable to not form the fins 15 (see FIG. 8) in the individual heatsink plate 10.

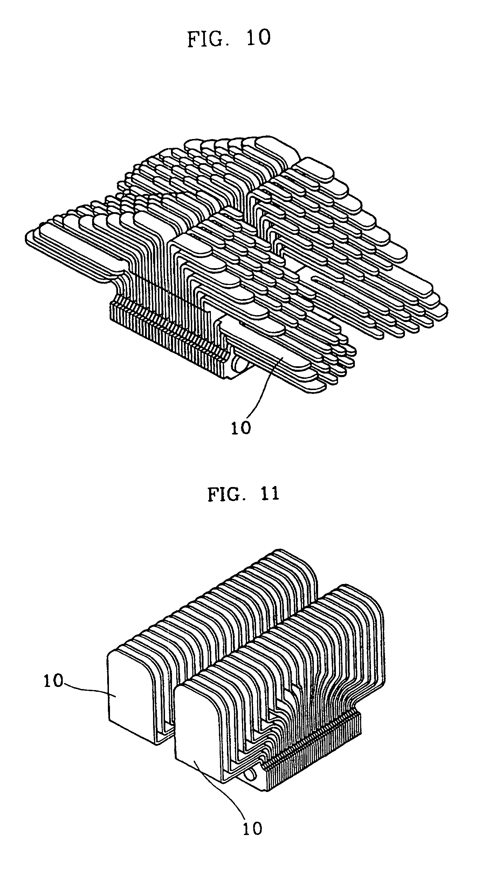

In order to reduce the height of the heatsink 1 as well as to allow smooth flow of air, each heatsink plate 10 may be bent 90E with a different step while the individual heatsink plates 10 are appropriately spaced. Also, to reduce both the height and width of the heatsink 1, each heatsink plate 10 may be bent 90E twice as shown in FIG. 11. In this case, the individual heatsink plates 10 are spaced apart an appropriate distance for smooth flow of air.

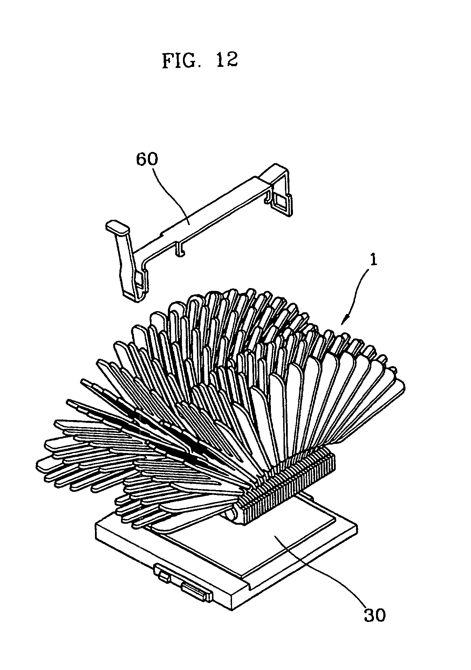

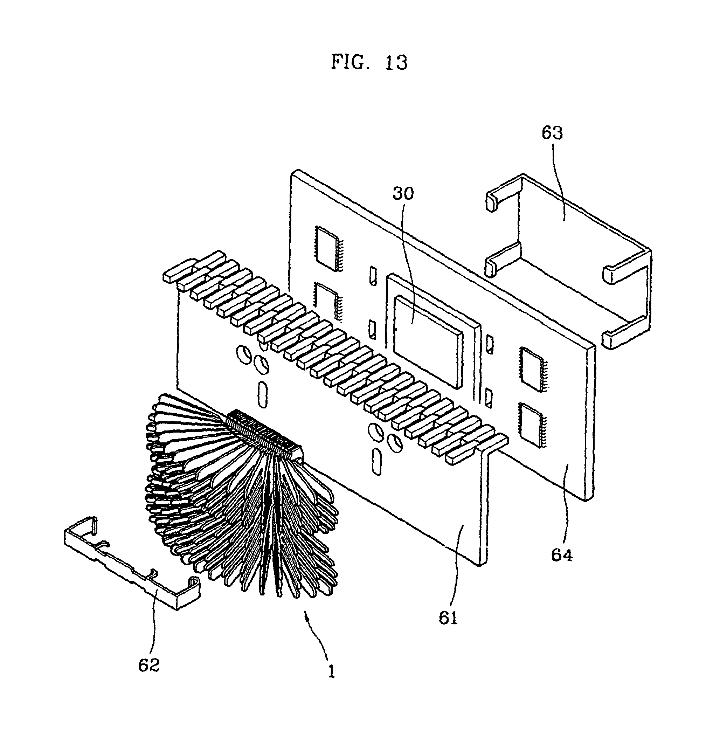

Referring to FIG. 12, the heatsink 1 according to the present invention is attached to the electronic component 30 by means of a bolt (not shown) or a clip 60. Also, a thermal conductive bond (not shown) or a thermal conductive tape (not shown) may be used to fix the heatsink 1 to a heat-generating source. In the case of using the clip 60, preferably, the heatsink 1 is designed such that a portion of the heatsink 1, which the clip 60 is fixed to, has no fins. Also, an auxiliary heat-dissipating plate 61 may be interposed between the heatsink 1 and the electronic component 30 to be cool, as shown in FIG. 13, depending on the type of the heat-producing electronic component. The heatsink 1 is fixed to the auxiliary heat-dissipating plate 61 by a first clip 62, and the auxiliary heat-dissipating plate 61 is fixed to a board 64, which the electronic component 30 has been mounted on, by a second clip 63. The role of the auxiliary heat-dissipating plate 61 is to fix the heatsink 1 to the board 64, and to dissipate heat by itself, thus increasing the heat-dissipating efficiency.

A variety of clips can be implemented depending on the type of CPU, which is a heat-generating electronic component. For example, the heatsink 1 may be fixed to a Socket 7 type CPU or a PPGA Socket 370 type CPU by using the clip 60 shown in FIG. 12. Also, preferably, the heatsink 1 can be fixed to a Slot A, Slot 1 or Slot 2 type CPU by using the first and second clips 62 and 63 shown in FIG. 13. The clips 60, 62 and 63 are characterized in that each clip is formed in a single body. Because the clips 60, 62 and 63 are formed in a single body, the manufacturing process thereof can be simplified, lowering the manufacturing cost, and the likelihood of breakage is reduced.

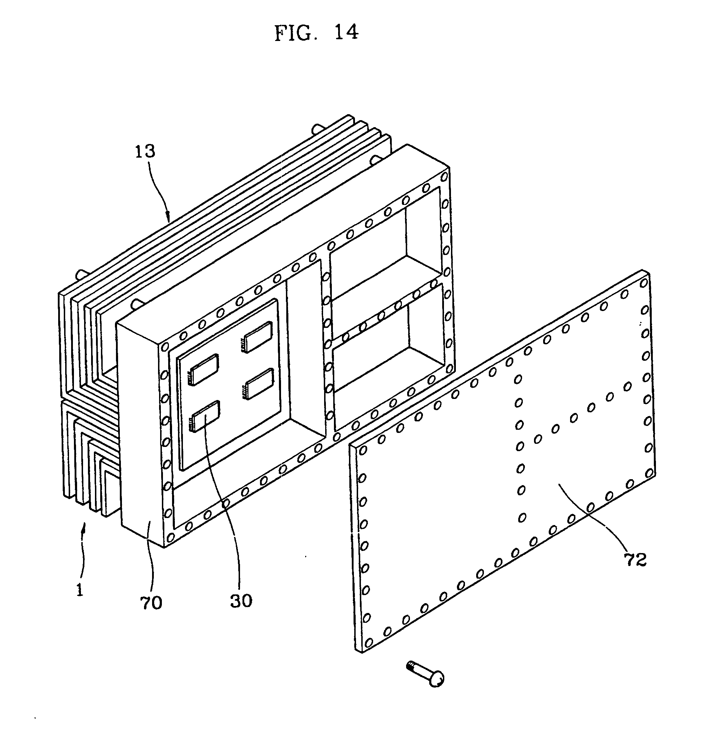

In the case where the electronic component 30 must be shielded from electric waves, as shown in FIG. 14, the electronic component 30 is fixed in a case 70 and covered by a case lid 72. Preferably, the heatsink 1 is installed outside the case 70, such that the heat-absorbing surface of the heatsink 1 contacts the outside of the case 70, to the opposite side of which the electronic component 30 is fixed. The heat generated from the electronic component 30 is transferred by conduction to the case 70, and a small amount of heat conducted to the case 70 is dissipated through the case 70 itself. The remaining heat is additionally conducted to the heatsink 1, which has a large heat conducting area, and then dissipated into air through the heat-dissipating portion 13 of the heatsink 1. Here, the heatsink 1 may be fixed to the case 70 through brazing or by means of a clip (not shown) or a bolt.

Referring to FIGS. 3 and 7, the heatsink 1 is formed of a metal having a high thermal conductivity, such as Cu or Al. Also, the size and the number of heatsink plates 10 and fins 15 formed in each heatsink plate 10 are determined in view of the amount of heat to be dissipated, whether a fan 20 is to be installed, and the position of the fan 20. In the case where a fan 20 is to be installed at a side of the heatsink 1, it is preferable to not form fins in the individual heatsink plates 10 to increase the heat conducting area and the heat dissipating area. For example, in the case of cooling a CPU manufactured by Intel or Advanced Micro Devices (AMD) where the rate of heat dissipation is 5-30 watts, it is preferable that the heat-dissipating area is 300-20,000 cm². If the heat dissipating area is smaller than 300 cm², the heat dissipating efficiency is not very good. Meanwhile, if the heat dissipating area is greater than 20,000 cm², the heat dissipating efficiency is great. However, it is difficult to manufacture a heatsink having such a large heat dissipating area.

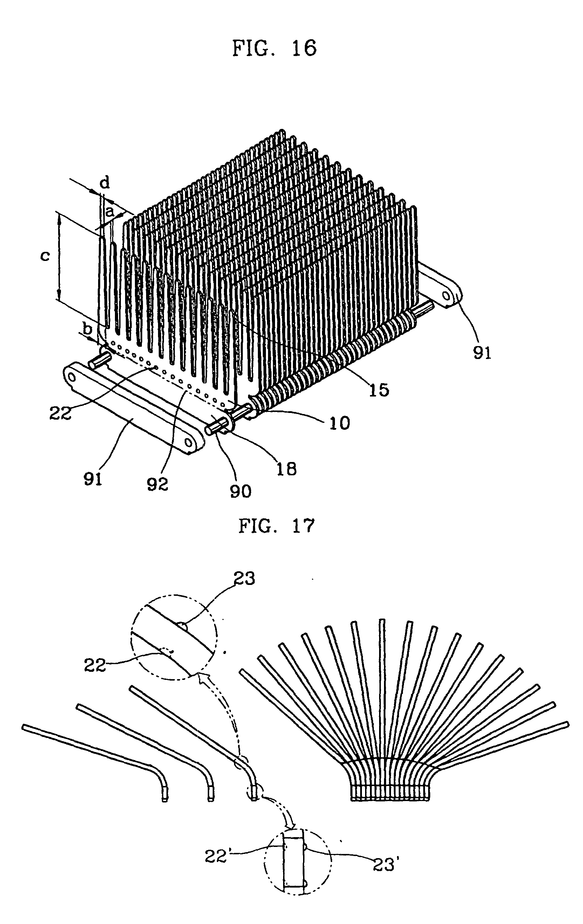

Referring to FIG. 16, preferably, the thickness a of the fin 15 formed in the individual heatsink plates 10 is in the range of 0.1-3 mm. If the thickness a of the fin 15 is equal to or less than 0.1 mm, the fins 15 are susceptible to bending which is not desirable. If the thickness a of the fin 15 is equal to or greater than 3 mm, the heat-dissipating area is reduced and the manufacturing process thereof is difficult. Also, it is preferable that the upper width **d** of the fin 15 is equal to or less than the lower width b of the fin 15. This is so that air can flow through and between the fins 15 unhindered. That is, if the upper width d is greater than the lower width **b,** the fins 15 are apt to bending due to its weight and external forces, thereby hindering air flow. For example, if there are 40 heatsink plates each having a thickness a of 1 mm and each plate has 16 fins with the dimension **b** = 3 mm, **c** = 40 mm, **d** = 2 mm, **a** = 1 mm, wherein **c** represents the length of the fin, the heat-dissipating area can be appropriately attained and manufacturing of the heatsink can still be achieved with relative ease.

Referring to FIG. 3, the binding means may be one of several well-known techniques. The heatsink plates 10 may be adhered to one another by a chemical adhesive or by lead, or through brazing. Alternatively, after forming holes 16 through the heatsink plates 10, the heatsink plates 10 may be combined by using nuts and bolts (not shown). A rivet 17 may also be used as the binding means. Several other binding means, such as , but not limited to, press bonding, a heat-conducting bond and lead solder, may be used. Using the rivet 17 to fix the heatsink plates 10 is most preferred among the above-mentioned binding means. Binding the heatsink plates 10 made of Al with an Al rivet, or binding the heatsink plates 10 made of Cu with a Cu rivet is preferable in view of recycling of resources. Also, using the same material in forming the heatsink plates 10 and rivet 17 contributes to the formation of a well-fitted heatsink, and lowers the manufacturing cost. The above-mentioned binding means does not hinder heat absorption from the heat-generating source by the heatsink. This is because the bottom surface of each heatsink plate 10 directly contacts the heat-generating source. In consideration of the possibility that the heatsink plates 10 may not directly contact the heat-generating source, the heatsink plates 10 made of Al may be fixed by the rivets 17 made of Cu, to facilitate heat conduction through the rivets 17 made of Cu having a high thermal conductivity. Also, as shown in FIG. 2, indentations 22' and protrusions 23' may be formed in the heatsink plates 10, which can prevent distortion of the heat-absorbing portion. If the heat-absorbing portion is distorted, the bottom surface of the individual heatsink plates 10 becomes uneven, so that the heat absorption efficiency through the heat-absorbing surface from a heat-generating electronic component decreases. Here, the shapes of indentations 22' and protrusions 23' are substantially complementary.

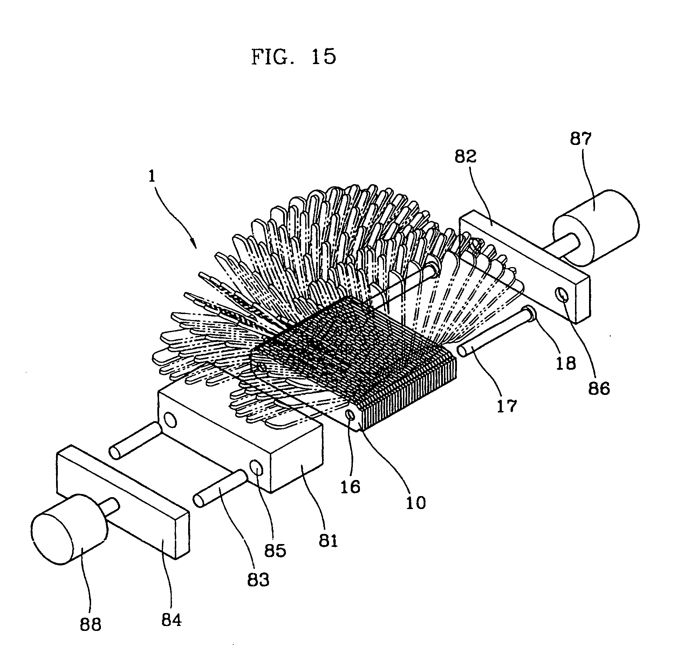

Referring to FIG. 15, when binding the heatsink plates 10 using the rivets 17, preferably, a riveting device is used. That is, the riveting device is required to tightly fix the individual heatsink plates 10 and to shape uniform heads 18 of the rivets 17. The riveting device includes a first jig 81, a second jig 82, a hammer 84 and pin hammers 83. The first jig 81 has holes for receiving the pin hammers 83, and the second jig 82 has holes 86 each for receiving the head 18 of the rivet 17. The first jig 81 is supported by a support (not shown) and the second jig 82 is connected to a compression cylinder 88. The hammer 84 is connected to the hammer cylinder 88 that compresses the pin hammer 83.

In riveting the individual heatsink plates 10 using the riveting device, the rivets 17 are inserted into the holes 16 of the heatsink plates 10, and the binding portion of the heatsink plates 10, where the holes 16 are formed, is placed between the first and second jigs 81 and 82. As the compression cylinder 87 is operated by a controller (not shown), the second jig 82 compresses the binding portion of the heatsink plates 10 against the first jig 81. The heads 18 of the rivets 17 are inserted into the holes 86, and the ends of the rivets 17, which have passed through the holes 16 formed in the heatsink plates 10, are inserted into the holes 85 of the first jig 81. As the hammer cylinder 88 operates, the hammer 84 pushes the pin hammers 83 into the holes 85 of the first jig 81, to compress the rivets 17, resulting in the formation of other heads (not shown) at the ends of the rivets 17. Here, the binding portion of the heatsink plates 10 are tightened by the first and second jigs 81 and 82, so that the heatsink plates 10 are hardly deformed. The size of the newly formed rivet heads can be varied by controlling the compression force by the hammer cylinder 88. Also, raised or depressed characters may be included on the inner sides of the first and second jigs 81 and 82, which contact the outermost binding portion of the heatsink plates 10, to imprint the corresponding characters on the outermost binding portion of the heatsink 1.

Referring to FIGS. 16 and 17, the heatsink plates 10 may be manufactured by various methods. For example, a heatsink plate 10 having a predetermined thickness can be formed of Al through press molding. Alternatively, a heatsink plate 10 may be formed through etching, wire-cutting or by laser cutting. Then, a plurality of heatsink plates 10, as many as needed to have a desired size, are stacked to one another, and each heatsink plate 10 is then folded at a predetermined angle along a folding line 92. In the case where the heatsink plate 10 is made of an Al plate through molding, preferably, a plurality of heatsink plates 10 are combined after punching indentations 22 into one side of each heatsink plate 10 such that protrusions 23 are formed at the opposite side thereof. After the protrusions 23 are formed in the heatsink plates 10, two assembly rods 90 are inserted into the holes of the heatsink plates 10, and then the binding portion of the individual heatsink plates 10 are brought tightly into contact with each other using jigs 91, such that the individual heatsink plates 10 are bent a predetermined angle along the folding line 92. Here, the folding angle of each heatsink plate 10 may be adjusted based on the shapes size of the indentations 22 and the protrusions 23. Also, by forming the indentations 22' and the protrusions 23' in the binding portion of the individual heatsink plates 10, which were described previously with reference to FIG. 2, distortion at the binding portion of the heatsink plate 10 can be avoided. Distortion of the binding portion results in an uneven heat-absorbing surface, and thus the heat absorption efficiency of the heat-absorbing surface, from a heat-generating electronic component, is lowered. Because the shapes of the indentations 22' and the protrusions 23' are complementary to each other, unlike the indentations 22 and the protrusion formed above the folding line 92, the protrusion 23' of a heatsink plate 10 may be pressed into the indentation 22N of the adjacent heatsink plate 10.

As shown in FIGS. 7 and 11, in the case where a heatsink plate 10 is formed by press-molding an Al plate, the plurality of heatsink plates 10 may be combined with each other after individually being folded at different angles. For example, if 30 individual heatsink plates 10 are to be combined it is only necessary to have 15 different degrees of bending of the heatsink plates 10 to form the complete heat sink 1. That is, two heatsink plates 10 can be bent at the same angle and one bent heatsink plates 10 can be flipped around to be the symmetrical counterpart of the other bent heatsink plates.

When a heatsink is completed, the heat-absorbing surface 12 is leveled through face-cutting. If the heatsink is made of Al, preferably, the Al heatsink is anodized or subjected to Al-chromate treatment. If Cu is used to form the heatsink, the Cu heatsink is preferably exposed to plating or subjected to Cu-chromate treatment.

### Industrial Applicability

The heatsink according to the present invention can be used for various purposes. That is, the heatsink can transfer heat generated by a heat-generating source into air without power consumption and without generating noise and vibrations. Also, the amount of heat to be transferred into air can be increased by using a fan together with the heatsink, although the fan produces noise. Also, in the method for manufacturing the heatsink according to the present invention, the angle between the heatsink plates can be easily controlled to a constant angle and its manufacturing cost can be kept low with a well-fitted structure.

While the present invention has been illustrated and described with reference to specific embodiments, further modifications and alterations within the spirit and scope of this invention as defined by the appended claims will occur to those skilled in the art.

## Claims

1. A heatsink for an electronic component comprising:
a plurality of heatsink plates (10), wherein the individual heatsink plates are bound together at a binding portion thereof, the bottom surface of the binding portion forming a heat-absorbing portion (12) for contacting a heat-dissipating surface of the electronic component (30), and portions of the heatsink plates opposite said heat-absorbing surface are separated from each other to collectively act as heat-dissipating portions (13), and
means (16,17) for binding the plurality of heatsink plates together.

2. The heatsink of claim 1, further comprising a plurality of spacers (11) each interposed between said binding portions of neighboring heatsink plates, thereby providing separation between the heat-dissipating portions of the heatsink plates.

3. The heatsink of claim 1, wherein the heatsink plates are spread out apart from each other by being bent at predetermined angles, thereby providing separation between the heat-dissipating portions of the heatsink plates.

4. The heatsink of any one of claims 1-3, wherein the heatsink plates are formed of a plurality of fins spaced apart from each other by a predetermined interval.

5. The heatsink of claim 2, wherein the spacers have extensions extending from the portion where the plurality of binding portions and the plurality of spacer are bound.

6. The heatsink of any one of claims 1-3 and claim 5, wherein the heatsink plates are bent at portions other than the binding portions at least once while the heatsink plates are spaced apart from each other at portions other than the binding portions.

7. The heatsink of claim 4, wherein the heatsink plates are bent at portions other than the binding portions at least once while the heatsink plates are spaced apart from each other.

8. The heatsink of any one of claims 1-3 and claim 5, wherein the binding means is a rivet (17).

9. The heatsink of claim 4, wherein the binding means is a rivet (17).

10. The heatsink of any one of claims 1-3 and claim 5, wherein a fan (20) is installed at the heatsink to blow air over the heatsink.

11. The heatsink of claim 4, wherein a fan (20) is installed at the heatsink to blow air over the heatsink.

12. The heatsink of any one of claims 1-3 and claim 5, wherein a fan (20) is fitted to a separate bracket and installed to the heatsink to blow air over the heatsink.

13. The heatsink of claim 4, wherein a fan (20) is fitted to a separate bracket and installed to the heatsink to blow air over the heatsink.

14. The heatsink of claim 2 or claim 5, wherein the binding portions of the individual heatsink plates and the spacers have at least one pair of a protrusion and an indentation which correspond to each other, respectively.

15. The heatsink of claim 3, further comprising a plurality of spacers interleaved between binding portions of the heatsink plates at the heat-absorbing portion

16. The heatsink of any one of claims 1-3 and claim 5, wherein the bottom surface of the heat-absorbing portion is substantially flat.

17. The heatsink of claim 4, wherein the bottom surface of the heat-absorbing portion is substantially flat.

18. The heatsink of claim 1 or claim 3 and claim 5, wherein the binding portions of the individual heatsink plates have at least one pair of a protrusion and an indentation which correspond to each other, respectively.

19. The heatsink of claim 4, wherein the binding portions of the individual heatsink plates have at least one pair of a protrusion and an indentation which correspond to each other, respectively.

20. An apparatus for manufacturing a heatsink as defined in claim 1, the heatsink being a combination of a plurality of heatsink plates (10), heatsink plates (10) having at least one corresponding binding hole (16) at a binding portion of the individual heatsink plates, the apparatus comprising:
a first jig (81) having at least one hole, corresponding to the number of binding holes in each said heatsink plate;
at least one pin hammer (83), corresponding to the number of binding holes in each said heatsink plate, to be inserted into the hole(s) of the first jig;
a second jig (82) having at least one groove, corresponding to the at least one hole (86) of said first jig, where the head of a rivet is inserted; and
a hammer (84) for pushing the pin hammer against a rivet passed through the binding holes of the individual heatsink plates to deform the end of the rivet such that another head is formed on the rivet,
wherein the individual heatsink plates are compressed between the first and second jigs at the binding portion (12) of the individual heatsink plates as the apparatus binds the individual heatsink plates together by riveting a rivet (17) through the binding holes at the binding portion of the individual heatsink plates.

21. The apparatus of claim 20, wherein the inner sides of the first and second jigs, contacting the binding portions of the heatsink plates have raised or depressed characters such that the characters can be carved into or molded at at least one outermost binding portion of the heatsink.

22. A method of manufacturing a heatsink as defined in claim 1, the heatsink being a combination of a plurality of heatsink plates (10), comprising:
(a) forming a binding hole (16) in each heatsink plate, the binding hole being used to bind the plurality of heatsink plates together;
(b) combining the plurality of heatsink plates (10);
(c) fixing the combined heatsink plates (10) by a fixing means (16,17); and
(d) flattening the bottom surface of a binding portion of the heatsink plates, which allows the bottom surface to contact a heat-dissipating surface of an electronic component.

23. The method of claim 22, further comprising:
forming at least one pair of a protrusion and an indentation in the binding portions of the heatsink plates, together with the binding hole, in the formation of the individual heatsink plates; and
pressing the binding portions of the heatsink plates together such that the protrusion of a heatsink plate is inserted into the indentation of the adjacent heatsink plate, thereby binding the individual heatsink plates at the binding portion thereof.

24. The method of claim 22 or 23, further comprising:
forming at least one pair of a protrusions and an indentation at a portion of the heatsink plates other than the binding portions, together with the binding hole in the formation of the heatsink plates; and
pressing the binding portion of the heatsink plates together, while an assembly rod is inserted into the binding hole such that the individual heatsink plates bend outward at predetermined angles at portions other than the binding portion.

25. The method of claim 22, wherein the step (b) comprises:
inserting a rivet having a head on one end into the binding hole of each of the heatsink plates;
sliding the binding portions of the heatsink plates towards the end of the rivet, from the end of the rivet that is opposite to the head; and
compressing the end of the rivet that has no head to form another head of the rivet, wherein the heatsink plates are held between the heads of the rivet.

## Patentansprüche

1. Kühlkörper für ein elektronisches Bauelement, der Folgendes umfasst: eine Vielzahl von Kühlkörperblechen (10), wobei die einzelnen Kühlkörperbleche in einem Verbindungsbereich hiervon verbunden werden, wobei die Bodenfläche des Verbindungsbereichs einen wärmeaufnehmenden Bereich (12) zur Kontaktaufnahme mit einer wärmeabgebenden Oberfläche des elektronischen Bauelements (30) bildet, und wobei Bereiche der Kühlkörperbleche gegenüber der wärmeaufnehmenden Oberfläche voneinander getrennt sind, um gemeinsam als wärmeabgebende Bereiche (13) zu wirken, und Mittel (16, 17), um die Vielzahl der Kühlkörperbleche miteinander zu verbinden.

2. Kühlkörper nach Anspruch 1, der ferner eine Vielzahl von Abstandshaltern (11) umfasst, die jeweils zwischen Verbindungsbereichen von benachbarten Kühlkörperblechen eingefügt sind, wodurch eine Trennung zwischen den wärmeabgebenden Bereichen der Kühlkörperbleche gewährleistet ist.

3. Kühlkörper nach Anspruch 1, wobei die Kühlkörperbleche getrennt voneinander gespreizt sind, indem sie in vorbestimmten Winkeln verbunden sind, wodurch eine Trennung zwischen den wärmeabgebenden Bereichen der Kühlkörperbleche gewährleistet ist.

4. Kühlkörper nach einem der Ansprüche 1 - 3, wobei die Kühlkörperbleche aus einer Vielzahl von Lamellen gebildet sind, die voneinander mit einem vorbestimmten Zwischenraum beabstandet sind.

5. Kühlkörper nach Anspruch 2, wobei die Abstandshalter Verlängerungen haben, die sich von dem Bereich aus erstrecken, in dem die Vielzahl der Verbindungsbereiche und die Vielzahl der Abstandshalter verbunden sind.

6. Kühlkörper nach einem der Ansprüche 1 - 3 und Anspruch 5, wobei die Kühlkörperbleche mindestens einmal in anderen Bereichen als den Verbindungsbereichen verbunden sind, während die Kühlkörperbleche voneinander in anderen Bereichen als den Verbindungsbereichen beabstandet sind.

7. Kühlkörper nach Anspruch 4, wobei die Kühlkörperbleche mindestens einmal in anderen Bereichen als den Verbindungsbereichen verbunden sind, während die Kühlkörperbleche voneinander beabstandet sind.

8. Kühlkörper nach einem der Ansprüche 1 - 3 und Anspruch 5, wobei das Verbindungsmittel ein Niet (17) ist.

9. Kühlkörper nach Anspruch 4, wobei das Verbindungsmittel ein Niet (17) ist.

10. Kühlkörper nach einem der Ansprüche 1 - 3 und Anspruch 5, wobei ein Ventilator (20) in den Kühlkörper eingebaut ist, um Luft über den Kühlkörper zu blasen.

11. Kühlkörper nach Anspruch 4, wobei ein Ventilator (20) in den Kühlkörper eingebaut ist, um Luft über den Kühlkörper zu blasen.

12. Kühlkörper nach einem der Ansprüche 1 - 3 und Anspruch 5, wobei ein Ventilator (20) an einer separaten Konsole befestigt und in den Kühlkörper eingebaut ist, um Luft über den Kühlkörper zu blasen.

13. Kühlkörper nach Anspruch 4, wobei ein Ventilator (20) an einer separate Konsole befestigt und in den Kühlkörper eingebaut ist, um Luft über den Kühlkörper zu blasen.

14. Kühlkörper nach Anspruch 2 oder Anspruch 5, wobei die Verbindungsbereiche der einzelnen Kühlkörperbleche und die Abstandshalter mindestes ein Paar eines Vorsprungs und einer Vertiefung aufweisen, die einander jeweils entsprechen.

15. Kühlkörper nach Anspruch 3, der ferner eine Vielzahl von Abstandshaltern umfasst, die zwischen Verbindungsbereichen der Kühlkörperbleche in dem wärmeaufnehmenden Bereich ineinander verschachtelt sind.

16. Kühlkörper nach einem der Ansprüche 1 - 3 und Anspruch 5, wobei die Bodenfläche des wärmeaufnehmenden Bereichs im Wesentlichen flach ist.

17. Kühlkörper nach Anspruch 4, wobei die Bodenfläche des wärmeaufnehmenden Bereichs im Wesentlichen flach ist.

18. Kühlkörper nach einem der Ansprüche 1 - 3 und Anspruch 5, wobei die Verbindungsbereiche der einzelnen Kühlkörperbleche mindestens ein Paar eines Vorsprungs und einer Vertiefung aufweisen, die einander jeweils entsprechen.

19. Kühlkörper nach Anspruch 4, wobei die Verbindungsbereiche der einzelnen Kühlkörperbleche mindestens ein Paar eines Vorsprung und einer Vertiefung aufweisen, die einander jeweils entsprechen.

20. Vorrichtung zum Herstellen eines Kühlkörpers nach Anspruch 1, wobei der Kühlkörper eine Kombination einer Vielzahl von Kühlkörperblechen (10) ist, die mindestens ein entsprechendes Verbindungsloch (16) in einem Verbindungsbereich der einzelnen Kühlkörperbleche aufweisen, wobei die Vorrichtung Folgendes umfasst: eine erste Spannvorrichtung (81) mit mindestens einem Loch entsprechend der Anzahl der Verbindungslöcher in jedem Kühlkörperblech; mindestens einen Hammerbolzen (83) entsprechend der Anzahl der Verbindungslöcher in jedem Kühlkörperblech, der in das Loch/die Löcher der ersten Spannvorrichtung einsetzbar ist; eine zweite Spannvorrichtung (82) mit mindestens einer Nut, die dem mindestens einen Loch (86) der ersten Spannvorrichtung entspricht, in welche der Kopf eines Niets eingebracht wird; und einen Hammer (84) zum Hineintreiben des Hammerbolzens gegen einen Niet, der durch die Verbindungslöcher der einzelnen Kühlkörperbleche gesteckt wurde, um das Ende des Niets so zu deformieren, dass auf dem Niet ein weiterer Kopf gebildet wird, wobei die einzelnen Kühlkörperbleche zwischen der ersten und zweiten Spannvorrichtung in dem Verbindungsbereich (12) der einzelnen Kühlkörperbleche zusammengedrückt werden, während die Vorrichtung die einzelnen Kühlkörperbleche durch Vernieten mit einem Niet (17) durch die Verbindungslöcher in dem Verbindungsbereich der einzelnen Kühlkörperbleche miteinander verbindet.

21. Vorrichtung nach Anspruch 20, wobei die Innenseiten der ersten und zweiten Spannvorrichtungen, die die Verbindungsbereiche der Kühlkörperbleche berühren, derartige erhabene oder vertiefte Zeichen haben, dass die Zeichen mindestens in einen äußersten Verbindungsbereich des Kühlkörperblechs eingeritzt oder aufgegossen werden können.

22. Verfahren zur Herstellung eines Kühlkörpers wie in Anspruch 1 definiert, wobei der Kühlkörper eine Kombination einer Vielzahl von Kühlkörperblechen (19) ist, das Folgendes umfasst:
(a) Bildung eines Verbindungsloches (16) in jedem Kühlkörperblech, wobei das Verbindungsloch zur Verbindung der Vielzahl der Kühlkörperbleche miteinander verwendet wird;
(b) Verbindung der Vielzahl von Kühlkörperblechen (10);
(c) Befestigung der verbundenen Kühlkörperbleche (10) durch ein Befestigungsmittel (16, 17); und
(d) Abflachung der Bodenfläche eines Verbindungsbereichs der Kühlkörperbleche, was es der Bodenfläche ermöglicht, mit einer wärmeabgebende Oberfläche eines elektronischen Bauteils Kontakt aufzunehmen.

23. Verfahren nach Anspruch 22, das ferner Folgendes umfasst:
Bildung von mindestens einem Paar eines Vorsprungs und einer Vertiefung in den Verbindungsbereichen der Kühlkörperbleche, zusammen mit dem Verbindungsloch bei der Zusammensetzung der einzelnen Kühlkörperbleche; und
Zusammenpressen der Verbindungsbereiche der Kühlkörperbleche, so dass der Vorsprung eines Kühlkörperblechs in die Vertiefung des angrenzenden Kühlkörperblechs eingefügt werden kann, wobei die einzelnen Kühlkörperbleche in dem Verbindungsbereich verbunden werden.

24. Verfahren nach Anspruch 22 oder 23, das ferner Folgendes umfasst:
Bildung von mindestens einem Paar eines Vorsprungs und einer Vertiefung in einem anderen Bereich der Kühlkörperbleche als dem Verbindungsbereich, zusammen mit dem Verbindungsloch bei der Zusammensetzung der Kühlkörperbleche; und
Zusammenpressen der Verbindungsbereiche der Kühlkörperbleche, während eine Montagestange in das Verbindungsloch eingefügt wird, so dass die einzelnen Kühlkörperbleche in vorbestimmten Winkeln in anderen Bereichen als den Verbindungsbereichen nach außen geneigt sind.

25. Verfahren nach Anspruch 22, wobei der Schritt (b) Folgendes umfasst:
Einfügen eines Niets, der einen Kopf aufweist, der an einem Ende in das Verbindungsloch von jedem der Kühlkörperbleche hineingeht;
Schieben der Verbindungsbereiche der Kühlkörperbleche auf das Nietende zu von dem Nietende aus, das gegenüber dem Kopf liegt; und Zusammendrücken des Nietendes, das keinen Kopf hat, um einen weiteren Kopf an dem Niet zu bilden, womit die Kühlkörperbleche zwischen den Nietköpfen gehalten werden.

## Revendications

1. Dissipateur thermique pour un composant électronique comprenant:
une pluralité de plaques de dissipateur (10), dans lequel les plaques de dissipateur individuelles sont liées ensemble à une partie de fixation de ces plaques, la surface du bas de la partie de fixation formant une partie absorbant la chaleur (12) pour être en contact avec une surface dissipant de la chaleur du composant électronique (30), et des parties des plaques de dissipateur opposées à ladite surface absorbant la chaleur sont séparées l'une de l'autre pour fonctionner collectivement comme des parties dissipant la chaleur (13), et
des moyens (16, 17) pour lier la pluralité de plaques de dissipateur ensemble.

2. Dissipateur thermique de la revendication 1, comprenant en outre une pluralité de pièces intercalaires (11) interposées chacune entre lesdites parties de fixation des plaques de dissipateur avoisinantes, définissant ainsi une séparation entre les parties dissipant la chaleur des plaques de dissipateur.

3. Dissipateur thermique de la revendication 1, dans lequel les plaques de dissipateur sont écartées éloignées l'une de l'autre en étant courbées à des angles prédéterminés définissant ainsi une séparation entre les parties dissipant la chaleur des plaques de dissipateur.

4. Dissipateur thermique de l'une quelconque des revendications 1-3, dans lequel les plaques de dissipateur sont formées d'une pluralité d'ailettes espacées l'une de l'autre par un intervalle prédéterminé.

5. Dissipateur thermique de la revendication 2, dans lequel les pièces intercalaires comportent des extensions s'étendant à partir de la partie où la pluralité des parties de fixation et la pluralité de pièces intercalaires sont liées.

6. Dissipateur thermique de l'une quelconque des revendications 1-3 et de la revendication 5, dans lequel les plaques de dissipateur sont courbées au moins une fois à des parties autres que les parties de fixation lorsque les plaques de dissipateur sont espacées l'une de l'autre à des endroits autres que les parties de fixation.

7. Dissipateur thermique de la revendication 4, dans lequel les plaques de dissipateur sont courbées au moins une fois à des parties autres que les parties de fixation lorsque les plaques de dissipateur sont espacées l'une de l'autre.

8. Dissipateur thermique de l'une quelconque des revendications 1-3 et de la revendication 5, dans lequel les moyens de fixation sont un rivet (17).

9. Dissipateur thermique de la revendication 4, dans lequel les moyens de fixation sont un rivet (17).

10. Dissipateur thermique de l'une quelconque des revendications 1-3 et de la revendication 5, dans lequel un ventilateur (20) est monté dans le dissipateur thermique pour souffler de l'air sur ledit dissipateur.

11. Dissipateur thermique de la revendication 4, dans lequel un ventilateur (20) est monté dans le dissipateur thermique pour souffler de l'air sur ledit dissipateur.

12. Dissipateur thermique de l'une quelconque des revendications 1-3 et de la revendication 5, dans lequel un ventilateur (20) est fixé sur un support séparé et monté dans le dissipateur thermique pour souffler de l'air sur ledit dissipateur.

13. Dissipateur thermique de la revendication 4, dans lequel un ventilateur (20) est fixé sur un support séparé et monté dans le dissipateur thermique pour souffler de l'air sur ledit dissipateur.

14. Dissipateur thermique de la revendication 2 ou de la revendication 5, dans lequel les parties de fixation des plaques de dissipateur individuelles et des pièces intercalaires comportent au moins une paire d'une protubérance et d'une découpure qui se correspondent respectivement.

15. Dissipateur thermique de la revendication 3, comprenant en outre une pluralité de pièces intercalaires entrelacées entre les parties de fixation des plaques de dissipateur dans la partie absorbant la chaleur.

16. Dissipateur thermique de l'une quelconque des revendications 1-3 et de la revendication 5, dans lequel la surface du bas de la partie absorbant la chaleur est sensiblement plate.

17. Dissipateur thermique de la revendication 4, dans lequel la surface du bas de la partie absorbant la chaleur est sensiblement plate.

18. Dissipateur thermique de la revendication 1 ou revendication 3 et revendication 5, dans lequel les parties de fixation des plaques de dissipateur individuelles comportent au moins une paire d'une protubérance et d'une découpure qui se correspondent respectivement.

19. Dissipateur thermique de la revendication 4, dans lequel les parties de fixation des plaques de dissipateur individuelles comportent au moins une paire d'une protubérance et d'une découpure qui se correspondent respectivement.

20. Appareil pour fabriquer un dissipateur thermique tel que défini dans la revendication 1, le dissipateur thermique étant une combinaison d'une pluralité de plaques de dissipateur (10), les plaques de dissipateur (10) ayant au moins un trou de fixation (16) correspondant à une partie de fixation des plaques de dissipateur individuelles, l'appareil comprenant :
un premier gabarit (81) comportant au moins un trou, correspondant au nombre de trous de fixation dans chaque plaque de dissipateur;
au moins une goupille à enfoncer (83) correspondant au nombre de trous de fixation dans chaque plaque de dissipateur, à insérer dans le/les trou(s) du premier gabarit;
un second gabarit (82) comportant au moins une rainure, correspondant à au moins un trou (86) dudit premier gabarit, où la tête du rivet est insérée; et
un marteau (84) pour pousser la goupille à enfoncer contre un rivet passé à travers les trous de fixation des plaques de dissipateur individuelles pour déformer l'extrémité du rivet de façon à ce qu'une autre tête soit formée sur le rivet,
dans lequel les plaques de dissipateur individuelles sont compressées entre les premier et second gabarits aux parties de fixation (12) des plaques de dissipateur individuelles lorsque l'appareil lie les plaques de dissipateur individuelles ensemble par rivetage d'un rivet (17) à travers les trous de fixation à la partie de fixation des plaques de dissipateur individuelles.

21. Appareil de la revendication 20, dans lequel les côtés intérieurs des premier et second gabarits, en contact avec les parties de fixation des plaques de dissipateur comportent des caractères en relief ou en creux de façon que les caractères puissent être gravés dans ou moulés avec au moins une partie de fixation la plus à l'extérieur du dissipateur thermique.

22. Procédé de fabrication d'un dissipateur thermique tel que défini dans la revendication 1, le dissipateur thermique étant une combinaison d'une pluralité de plaques de dissipateur (10), comprenant:
(a) la formation d'un trou de fixation (16) dans chaque plaque de dissipateur, le trou de fixation étant utilisé pour lier la pluralité de plaques de dissipateur ensemble;
(b) la combinaison de la pluralité de plaques de dissipateur (10);
(c) la fixation les plaques de dissipateur (10) combinées par des moyens de fixation (16, 17); et
(d) l'aplanissement de la surface du bas de la partie de fixation des plaques de dissipateur, ce qui permet à la surface du bas d'être en contact avec une surface dissipant de la chaleur d'un composant électronique.

23. Procédé de la revendication 22 comprenant en outre:
la formation d'au moins une paire d'une protubérance et d'une découpure dans les parties de fixation des plaques de dissipateur, ensemble avec le trou de fixation, lors de la formation des plaques de dissipateur individuelles; et
le pressage ensemble des parties de fixation des plaques de dissipateur de façon que la protubérance d'une plaque de dissipateur soit insérée dans la découpure de la plaque de dissipateur adjacente, liant ainsi les plaques de dissipateur individuelles à la partie de fixation de ces plaques.

24. Procédé de la revendication 22 ou 23 comprenant en outre:
la formation d'au moins une paire d'une protubérance et d'une découpure dans une partie des plaques de dissipateur autre que les parties de fixation, ensemble avec le trou de fixation lors de la formation des plaques de dissipateur; et
le pressage ensemble de la partie de fixation des plaques de dissipateur pendant qu'une tige d'assemblage est insérée dans le trou de fixation de façon que les plaques de dissipateur individuelles se courbent vers l'extérieur à des angles prédéterminés à des parties autres que la partie de fixation.

25. Procédé de la revendication 22, dans lequel l'étape (b) comprend ;
l'insertion d'un rivet ayant une tête à une extrémité dans le trou de fixation de chacune des plaques de dissipateur ;
le coulissement des parties de fixation des plaques de dissipateur vers l'extrémité du rivet, à partir de l'extrémité du rivet qui est opposée à la tête; et
la compression de l'extrémité du rivet qui n'a pas de tête pour former une autre tête du rivet, dans lequel les plaques de dissipateur sont tenues entre les têtes du rivet.
